# EUROPÄISCHE PATENTSCHRIFT

(11) **EP 1 211 110 B1**
(45) Veröffentlichungstag und Bekanntmachung des Hinweises auf die Patenterteilung: **23.08.2006**
(21) Anmeldenummer: 01127179.8
(22) Anmeldetag: 16.11.2001
(51) Int. Cl.: B60J 1/20

(54) **Fensterrollo mit Ausgleich gegen Verzug**
Roller blind with compensation against distortion
Store à enrouler avec compensation contre déformation

(30) Priorität: 22.11.2000 DE 10057762
(43) Veröffentlichungstag der Anmeldung: 05.06.2002
(73) Patentinhaber: BOS GmbH & Co. KG, 73760 Ostfildern (DE)
(72) Erfinder: Schlecht, Werner P., 71665 Vaihingen/Enz (DE); Walter, Herbert, 73061 Ebersbach (DE)
(74) Vertreter: Rüger, Barthelt & Abel Patentanwälte

(56) Entgegenhaltungen:
- EP-A- 0 775 605
- DE-U- 1 961 947
- DE-U- 1 964 155
- DE-U1- 29 621 563
- US-A- 4 758 041
- US-A- 5 201 810
- US-A- 6 086 133

## Beschreibung

Moderne Karosserieformen zeichnen sich durch verhältnismäßig große Fensterflächen aus. Die großen Fensterflächen führen wegen der starken Sonneneinstrahlung zu einer erheblichen Aufheizung des Fahrzeuginneren, und bei Fahrzeugen mit Klimaanlagen bedeutet die starke Aufheizung einen nicht unbeträchtlichen Energieverbrauch, um der Fahrzeugaufheizung entgegenzuwirken.

Die Kraftfahrzeuge werden deswegen in zunehmendem Maße mit Fensterrollos ausgerüstet.

Hierzu ist es bekannt, seitlich neben dem Heckfenster zwei Führungsschienen anzubringen, in denen der Zugstab der Rollobahn endseitig geführt ist. Der Zugstab ist längenverstellbar, um der unterschiedlichen Fensterbreite folgen zu können. Die Betätigung geschieht durch die in den Führungsschienen laufende Schubglieder.

Die Schubglieder sind nur mit sehr großem Aufwand hinreichend genau zu justieren, damit sie die Zugstange der Rollobahn exakt parallel zu der Wickelwelle bewegen. Wenn die Parallelität fehlt kommt es zu einem Schrägzug in der Rollobahn, mit der Folge von schräg sich erstreckenden Wellen in der ausgefahrenen Rollobahn. Dies sieht unschön aus und wird beanstandet.

Auch bei Seitenfensterrollos liegen gegebenenfalls ungünstige Verhältnisse vor, weil der Fensterausschnitt nicht rechtwinklig ist.

Aus der US-A-5201810 ist folgendes bekannt:
Fensterrollo zum Regulieren des Lichteintritts durch ein Fenster in einen Innenraum eines Kraftfahrzeugs,
mit wenigstens einer Wickelwelle, die drehbar gelagert ist,
mit wenigstens einer Rollobahn, die mit einer Kante an der Wickelwelle befestigt ist, deren dazu parallele Kante mit einem zugehörigen Zugstab verbunden ist und die seitliche Längskanten aufweist,
mit wenigsten einem Paar von Führungsmitteln, von denen sich jedes seitlich neben der aufgespannten Rollobahn erstreckt und in denen der Zugstab endseitig geführt ist,
mit einer Antriebseinrichtung, die ein erstes und ein zweites Antriebsglied aufweist, das derart angeordnet ist, dass ein Wirkende des ersten Antriebsglieds mit dem einen Ende des Zugstabs und das Wirkende des zweiten Antriebslieds mit dem anderen Ende des Zugstabs zusammenwirkt.

Zum Ausgleich der nicht rechteckigen Fensterform ist es aus der DE 296 21 563 U1 bekannt, die Wickelwelle an einer mittleren Stelle bezüglich einer Schwenkachse zu lagern, die rechtwinklig zu der Wickelwelle verläuft. Auf diese Weise soll es möglich sein, dass ohne Schiefziehen der Rollobahn die Zugstange im eingefahrenen Zustand möglichst parallel zu dem Auslaufschlitz verläuft, sich andererseits bei ausgefahrenem Rollo an den Verlauf der Fensteroberkante anpassen kann.

In der DE 196 19 474 C1 ist beschrieben, die Zugstange von Heckscheibenrollos endseitig in Führungsnuten von Führungsschienen zu führen. Zum Abziehen der Rollobahn von der Wickelwelle gegen die Wirkung eines Federmotors sind knicksteif geführte Schubglieder vorgesehen, die mit Hilfe eines Elektromotors in Gang gesetzt werden.

Die DE 196 41 554 C1 zeigt ein Heckscheibenrollo, das mit Hilfe von Hebeln aufgespannt wird. Auf der Hutablage ist eine Wickelwelle drehbar gelagert, neben der zwei Schwenkhebel angelenkt sind, die um eine zu der Rollowelle rechtwinklige Achse zu schwenken sind. Die freien Enden der Hebel greifen an der Zugstange der Rollobahn an und sind mit Hilfe von Federn in eine Stellung mit ausgefahrener Rollobahn vorgespannt. Die Wickelwelle wird über einen selbsthemmenden Elektromotor mit zwischengeschaltetem Getriebe angetrieben.

Zum Ausfahren der Rollobahn wird der Getriebemotor im Sinne des Abwickelns der Rollobahn in Gang gesetzt. Dabei schwenken die Hebel nach oben und erreichen die mechanische Endstellung noch bevor das gesamte Rollobahnmaterial von der Wickelwelle abgewickelt ist. Trotzdem läuft der Motor über diese Stellung hinaus und wickelt die Rollobahn mit entgegengesetztem Wickelsinn auf der Wickelwelle wieder auf. Um zu erkennen, ob die Rollobahn wieder gestrafft ist und der Motor abgeschaltet werden kann, ist die Wickelwelle an ihrem von dem Motor abliegenden Ende mit einem Lagerzapfen in einem Langloch gelagert. Am oberen Ende des Langloches sitzt ein Endschalter, der bei erneut gespannter Rollobahn betätigt wird. Damit kommt im ausgefahrenen Zustand die Rollobahn in eine Zwangslage. Diese Zwangslage spielt bei Hebelrollos keine Rolle, weil Toleranzen, die zu einem Schiefziehen der Rollobahn führen könnten, hier nicht auftreten können.

Ausgehend hiervon ist es Aufgabe der Erfindung ein Fensterrollo für Kraftfahrzeuge zu schaffen, bei dem ungenau justierte Schubglieder keinen Verzug in der Rollobahn erzeugen können.

Diese Aufgabe wird erfindungsgemäß mit dem Fensterrollo mit den Merkmalen der Ansprüche 1 oder 2 gelöst.

Die Verlagerung aus der Solllage entsteht im Wesentlichen, weil die Antriebsglieder, die der Bewegung des Zugstabs dienen, von der Wickelwelle einen anderen als den nominell notwendigen effektiven Abstand aufweisen. Eine andere Ursache für ein Schiefziehen der Rollobahn ist ein von vornherein nicht entsprechend der Solllage verlaufender Zugstab, der mit exakt justierten Antriebsgliedern zusammenwirkt.

Wenn beispielsweise die Antriebsglieder als Schubglieder arbeiten und synchron durch einen Elektromotor bewegt werden, im Sinne einer Mitnahme des Zugstabs zum Ausziehen der Rollobahn, entsteht ein ungleicher Zug in der Rollobahn mit der Folge der Wellenbildung, wenn das eine Schubglied voreilt und dadurch den Zugstab aus seiner natürlichen Lage verdrückt, die bei einem Heckfenster beispielsweise parallel zu der Rollowelle liegt.

Die Problematik der Verlagerung des Zugstabs und der Justage wird erschwert, weil die Antriebsglieder formschlüssig mit dem Getriebemotor zusammenwirken. Dadurch kann zwischen den beiden Antriebsgliedern ein Versatz von bis fast einer Zahnteilung auftreten, was in der Praxis etwa zwischen 3 und 6 mm ausmacht. Hinzu kommt noch die Toleranz, mit der die Rollobahn hergestellt ist. Aufgrund von Näh- und Zuschnitttoleranzen kann der Zugstab von Haus aus einen Parallelitätsfehler gegenüber der Wickelwelle zeigen.

Wenn sich diese Toleranzen ungünstig überlagern, sind Fehler von bis zu 10 mm oder mehr nicht ausgeschlossen. Ein derartiger effektiver Versatz führt zu einer schiefen Belastung der Rollobahn, mit der Folge der schräg sich erstreckenden Wellen oder Falten in der Rollobahn.

Grundsätzlich ähnliche Verhältnisse liegen auch bei Seitenfenstern vor. Allerdings hat hier der Zugstab gegenüber der Wickelwelle ohnehin eine schräge Lage, d.h. in der Solllage liegt der Zugstab schräg zu Wickelwelle. Wenn in diesem Falle die Schubglieder versetzt angreifen und die natürliche Lage des Zugstabs gewaltsam verändern, kommt es ebenfalls zur Wellenbildung.

Die erfindungsgemäße Ausgleichseinrichtung sorgt selbsttätig dafür, dass die Verlagerung des Zugstabs aus der jeweiligen Solllage (schräg oder parallel) zumindest nur in vermindertem Maße auftritt und keine sichtbare Wellenbildung in der Rollobahn hervorgerufen wird.

Für die Ausgleichseinrichtung kommen grundsätzlich mehrere prinzipielle Lösungen in Frage.

Bei der einen Lösung ist die Wickelwelle der Rollobahn in einem Bügel gelagert, der seinerseits um eine Querachse begrenzt pendeln kann.

Die Achse liegt bevorzugt in der Mitte, bezogen auf die Längserstreckung der Wickelwelle. Dadurch kann sich die Wickelwelle so einstellen, dass der Zugstab die Solllage bezüglich der Wickelwelle beibehält.

Anstatt die Wickelwelle in einem Bügel zu lagern, kann das gleiche Ziel auch erreicht werden, wenn die Wickelwelle an einem Ende in einem ortsfesten Lager, das begrenzt schwenkbar ist oder für die Wickelwelle ein entsprechendes Kippspiel bereithält, gelagert ist, während sich die Wickelwelle in dem anderem Lager in Richtung parallel zu jener Ebene weitgehend frei bewegen kann, die zu jener Ebene parallel ist, die durch die aufgespannte Rollobahn definiert ist.

Um Toleranzfehler nach beiden Richtungen zu kompensieren, hat selbstverständlich die Wickelwelle in der Ruhelage eine umgekehrte Neigung.

Bevorzugt ist jenes Lager ortsfest, das gleichzeitig als Verankerung für den Federmotor dient. Es reicht dann aus, wenn für die andere Lagerbohrung ein Langloch vorgesehen ist, in der ein Lagerzapfen verschieblich aufgenommen ist.

Die Führungsmittel bei dem erfindungsgemäßen Fensterrollo bestehen bevorzugt in Führungsschienen, in denen Führungsnuten enthalten sind.

Die Führungsnuten können gleichzeitig dazu verwendet werden, die Schublieder ausknicksicher zu führen.

Der Antrieb wird besonders einfach, wenn die Wickelwelle mit Hilfe eines Federmotors im Aufwickelsinne der Rollobahn vorgespannt ist. Die Wickelwelle folgt dann zwangsläufig der Bewegung der Rollobahn, wie sie durch den Elektromotor und die Antriebsglieder an den Zugstab vorgegeben ist.

Die Rollobahn kann aus einem Gewirk oder einer gelochten oder eingefärbten Folie bestehen.

Der Zugstab ist bei Fenstern, deren Fläche von der Rechteckform abweicht, längenveränderlich um den sich ändernden Abstand der Führungsschienen folgen zu können.

Im übrigen sind Weiterbildungen der Erfindung Gegenstand von Unteransprüchen. Dabei sollen auch solche Merkmalskombinationen als beansprucht gelten, für die es kein explizites Ausführungsbeispiel gibt.

In der Zeichnung sind Ausführungsbeispiele des Gegenstandes der Erfindung dargestellt. Es zeigen:
- Fig. 1: einen Pkw in einer Rückansicht, unter Veranschaulichung eines erfindungsgemäßen ausgezogenen Heckscheibenrollos,
- Fig. 2: den prinzipiellen Aufbau des Heckscheibenrollos nach Fig. 1,
- Fig. 3: die Führungsschiene des Heckscheibenrollos nach Fig. 1, in einem Querschnitt,
- Fig. 4: die Lagerung der Wickelwellen des Heckscheibenrollos nach Fig. 1, in einer schematisierten vereinfachten Darstellung,
- Fig. 5: den Antrieb des Heckscheibenrollos nach Fig. 1, in einer einfachen schematisierten Darstellung, und
- Fig. 6: ein weiteres Ausführungsbeispiel für die Lagerung der Wickelwelle zur Realisierung der Ausgleichseinrichtung, in einer perspektivischen Darstellung.

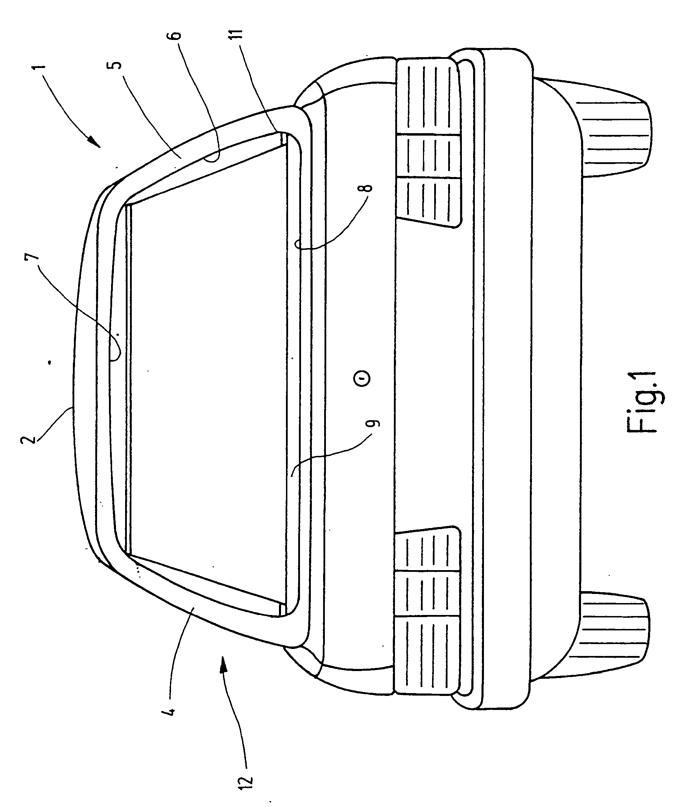

Fig. 1 zeigt in einer schematischen Darstellung die Rückansicht eines Pkw 1 mit einem Dach 2, einem Kofferraum 3 sowie zwei C-Säulen 4 und 5. Zwischen den beiden C-Säulen 4 und 5 befindet sich eine Heckfensteröffnung 6, die nach oben von einer Dachhinterkante 7 und nach unten von einer Fensterbrüstung 8 grenzen. In der Heckfensteröffnung 6 sitzt in bekannter Weise, beispielsweise mittels Fenstergummi eingeklebt, eine Heckscheibe.

Im Inneren des Pkw 1 befindet sich vor der Innenseite der Heckscheibe eine Hutablage 9, die sich zwischen der Fensterunterkante 8 und einer in der Figur nicht erkennbaren Rücksitzlehne horizontal erstreckt. In der Hutablage 9 verläuft ein gerader Auslaufschlitz 11.

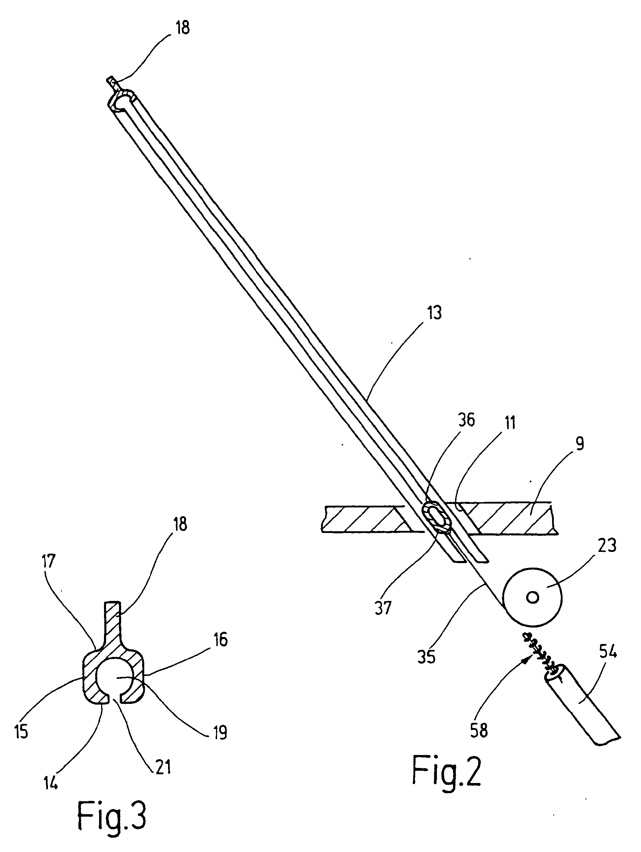

Der Auslaufschlitz 11 gehört zu einem Heckfensterrollo 12, dessen prinzipieller Aufbau in Fig. 2 stark schematisiert in einer Seitenansicht veranschaulicht ist.

Das Heckfensterrollo 12, weist zwei Führungsschienen 13 auf, die neben den seitlichen Rändern der Heckfensteröffnung 7 an den beiden C-Säulen 4 und 5 befestigt ist. Wegen der aufgeschnittenen Prinzipdarstellung ist in Fig. 2 lediglich eine Führungsschiene 13 zu erkennen, die beispielsweise an der C-Säule 5 befestigt ist.

Die Führungsschiene 13 weist das in Figur 3 gezeigte Querschnittsprofil auf. Sie ist im Querschnitt im Wesentlichen quadratisch mit abgerundeten Ecken und wird von einer Vorderseite 14, zwei seitlichen Wänden 15 und 16 sowie einer Rückseite 17 begrenzt. Von der Rückseite 17 geht ein leistenartiger Befestigungsflansch 18 aus, mit dessen Hilfe die Führungsschiene 13 an entsprechenden Karosserieteilen zu befestigen ist.

In der Führungsschiene 13 ist eine im Querschnitt kreisförmige Führungsnuten 19 enthalten, die sich über einen Schlitz 21 zu der Vorderseite 14 hin öffnen.

Die Führungsschiene 13 besteht beispielsweise aus einem Aluminiumstrangpressprofil.

Da der Schlitz 21 schmäler ist als der Durchmesser des kreisförmigen Abschnitts der Führungsnut 19, entsteht eine hinterschnittene Nut, die geeignet ist ein linienförmiges Schubglied gegen Ausknicken zu schützen und das Schubglied bei entsprechendem Durchmesser daran zu hindern, durch den Schlitz 21 nach außen auszutreten.

Die Führungsschienen 13 sind bzgl. mehrerer Achsen gebogen, damit sie der Kontur der Fensterkante folgen ohne in dem Fenster selbst sichtbar zu werden. Die Führungsschienen 13 sind so angeordnet, dass die Nuten 19 sich in Richtung aufeinander zu öffnen.

Die Führungsschienen 13 reichen nach unten, wie Figur 2 erkennen lässt, durch den Schlitz 11 bis unterhalb der Hutablage 9.

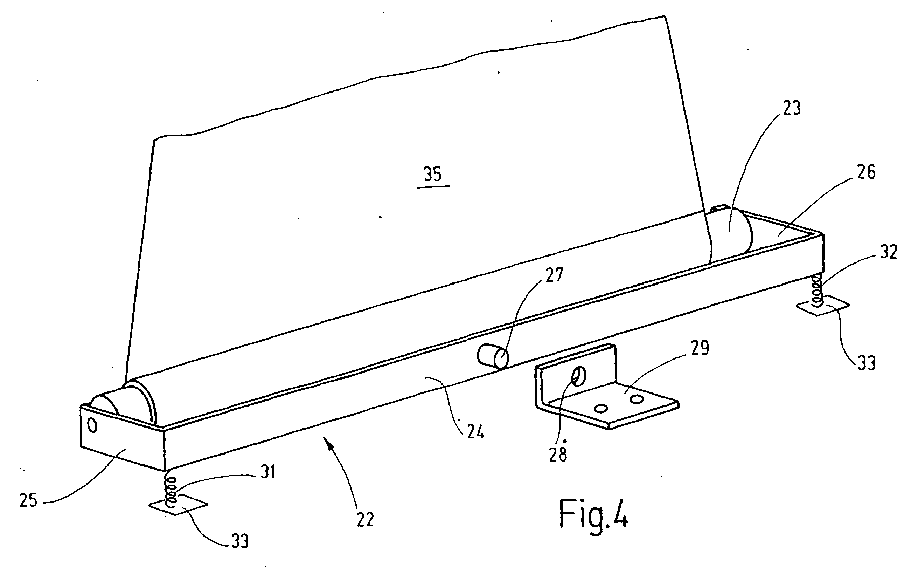

Unterhalb der Hutablage 9 ist, wie Figur 4 zeigt, in einem Lagerbügel 22 eine Wickelwelle 23 drehbar gelagert.

Der Lagerbügel 22 zur Lagerung der Wickelwelle 23 ist ein U-förmiges Gebilde mit einem Rückenteil 24 und zwei rechtwinklig davon ausgehenden Schenkeln 25 und 26, in denen die Wickelwelle 23 mit entsprechenden Lagerzapfen drehbar gelagert ist.

In der Mitte des Rückenabschnittes 24, befindet ein Lagerzapfen 27, dessen Achse rechtwinklig zu der Achse der Wickelwelle 23 verläuft. Der Lagerzapfen 27 sitzt in einer Lagerbohrung 28 eines Halters 29, der unterhalb der Hutablage 9 in dem Fahrzeug fest verankert ist. Auf diese Weise kann sich die Wickelwelle 23 begrenzt bzgl. der Achse, definiert durch den Lagerzapfen 27, drehen.

Die mittlere Stellung, d.h. die zentrierte Stellung wird durch zwei Druckfedern 31 und 32 vorgegeben, die sich einends an dem Lagerbügel 24 und anderenends an einer karosseriefesten Auflage 33 abstützen, die schematisch angegeben ist. Die beiden Federn 31 und 32 sitzen an der Übergangsstelle des Rückenteils 24 in den jeweiligen Schenkel 25 oder 26, so dass gleiche Drehmomente entstehen.

Die Wickelwelle 23 ist rohrförmig und beherbergt einen Federmotor 34. Der Federmotor 34 besteht aus einer Schraubenfeder, die mit einem Ende im Inneren der Wickelwelle 23 festgelegt ist und anderenends an dem Lagerbügel 22 verankert ist.

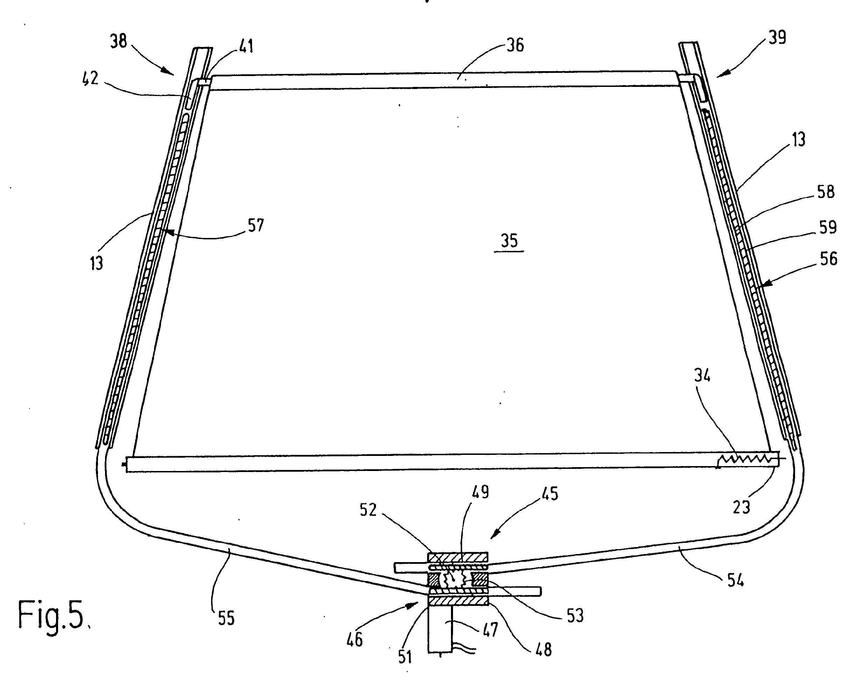

An der Wickelwelle 23 ist mit einer Kante eine Rollobahn 35 befestigt, deren Zuschnitt eine trapezförmige Annäherung der Kontur des Heckfensters 6 ist. Die von der Wickelwelle 23 abliegende Kante ist zu einer schlauchförmigen Schlaufe 36 geformt, in der ein Zugstab 37 sitzt. Der Zugstab 37 besteht aus einem formsteifen Rohr, in das zwei L-förmige Führungsglieder 38 und 39 von beiden Enden her eingesteckt sind, wie dies Figur 5 veranschaulicht.

Das Führungsglied 38 besteht aus einem langen, in dem formsteifen Rohr verschieblichen Schenkel 41 und einem L-förmig abgewinkelten Schenkel 42. Der Schenkel 41 ist an den Querschnitt des formsteifen Rohres angepasst und so bemessen, dass er durch den Schlitz 21 in das Innere der betreffenden Führungsnut 19 reichen kann. Der Schenkel 42 dagegen ist an den Querschnitt des kreisförmigen Teils der Führungsnut 19 angepasst. Auf diese Weise ist der Schenkel 41 in dem formsteifen Rohr längsverschieblich und der Schenkel 42 kann entlang der betreffenden Führungsnut 19 laufen. Er ist seitlich nicht aus dem Schlitz 21 herausziehbar.

Das Führungsglied 39 hat den gleichen Aufbau wie das Führungsglied 38, so dass sich eine neue Erläuterung insoweit erübrigt.

Um die Rollobahn 35 auszufahren ist eine Antriebseinrichtung 45 vorgesehen, die in Figur 5 stark schematisiert gezeigt ist. Zur Vereinfachung der Darstellung und zur Erläuterung des Verständnisses der Erfindung sind die beiden seitlichen Führungsschienen 13 in Figur 5 gedreht veranschaulicht, in der Weise, dass die beiden Führungsnuten 19 auf den Betrachter zeigen. Diese Darstellung ist wie gesagt nur zur Erleichterung des Verständnisses vorgenommen worden. In Wahrheit öffnen sich die beiden Führungsnuten 19 in Richtung aufeinander zu und nicht in Richtung auf den Betrachter.

Zu der Antriebseinrichtung 45 gehört ein Getriebemotor 46, der sich aus einem permanent erregten Gleichstrommotor 47 und einem Getriebegehäuse 48 zusammensetzt. In dem Getriebegehäuse sind parallel zueinander zwei Führungskanäle 49 und 51 enthalten, zwischen denen auf einer Ausgangswelle 52 ein Ausgangszahnrad 53 vorgesehen ist. Das Ausgangszahnrad 53 kann über die damit drehfest verbundene Ausgangswelle 52 wahlweise in beiden Drehrichtungen in Gang gesetzt werden.

Von dem Führungskanal 49 geht ein Führungsrohr 54 zu dem unteren Ende der Führungsnut 19 in der rechten Führungsschiene 13. Der Führungskanal 51 ist am linken Ende über ein Führungsrohr 55 mit dem unteren Ende der Führungsnut 19 in der linken Führungsschiene 13 verbunden.

Sowohl durch den Führungskanal 49 als auch durch den Führungskanal 51 verläuft jeweils ein biegeelastisches Schubglied 56 bzw. 57. Der jeweils nicht benutzte Teil der Schubglieder 56, 57 wird in Speicherrohre zurückgeschoben, die von dem jeweils anderen Ende der Führungskanäle 49, 51 ausgehen.

Die beiden Schubglieder 56 und 57 haben denselben Aufbau. Sie bestehen jeweils aus einer elastisch biegsamen Seele 58, der auf seiner Außenseite eine oder mehrere Rippen 59 trägt, die dort ein ein- oder mehrgängiges Gewinde bilden. Die Rippen 59 stehen radial vor und laufen schraubenförmig über die zylindrische Seele 58 von einem Ende des Schubglieds bis zum anderen Ende. Das Ausgangszahnrad 53 trägt eine Verzahnung, die zwischen die von den Rippen 59 gebildeten Nuten eingreifen kann. Auf diese Weise ist das Ausgangszahnrad 53 formschlüssig mit den Schubgliedern 56 und 57 gekuppelt.

Die Funktionsweise des beschriebenen Heckfensterrollos ist wie folgt:

In der Ruhestellung ist unter der Wirkung des Federmotors 34 die Wickelwelle 23 in eine Stellung gedreht, in der die Rollobahn 35 aufgewickelt ist. In dieser Stellung befindet sich die schlauchartige Schlaufe 36 in dem Auslaufschlitz 11, wie dies Figur 2 erkennen lässt. Die Führungsglieder 38, 39 liegen in der Nähe der unteren Enden der beiden Führungsschienen 13, ohne dass jedoch die Schenkel 42 aus den zugehörigen Führungsnuten 19 freigekommen sind.

Gleichzeitig sind die beiden Schubglieder 56 und 57 mit ihren beiden Enden von den betreffenden Schenkeln 42 beabstandet.

Wenn der Benutzer ausgehend von dieser Stellung des Heckfensterrollos 12, in der der Lichteintritt in das Fahrzeuginnere überhaupt nicht beeinflusst wird, eine Abschattungswirkung erzeugen möchte, fährt er die Rollobahn 35 aus. Die Rollobahn 35 vermindert den Lichtdurchtritt ohne ihn vollständig zu unterbinden. Hierzu besteht die Rollobahn 35 beispielsweise aus einem offnen Kettengewirk oder einer gelochten und schwarz eingefärbten Kunststofffolie.

Um die Rollobahn 35 auszufahren, wird der Getriebemotor 46 mit einer solchen Drehrichtung in Gang gesetzt, dass er das Schubglied 56 nach rechts durch in die Führungsnut 19 bewegt. Da die beiden Schubglieder 56 und 57 an diametral gegenüberliegenden Seiten mit dem Ausgangszahnrad 53 kämmen, wird gleichzeitig das Schubglied 57 nach links durch die Führungsnut 19 der linken Führungsschiene 13 vorgeschoben. Nach einem kurzen Stück des Vorschubwegs kommen die freien Enden der beiden Schubglieder 56 und 57 mit den unteren Enden der Schenkel 42 der beiden Führungsglieder 38 und 39 in Eingriff und schieben im weiteren Verlauf die Führungsglieder 38 und 39 in Richtung auf das obere Ende der beiden Führungsschienen 13.

Da sich der Abstand zwischen den Führungsschienen verändert, tauchen gleichzeitig teleskopartig die Schenkel 41 der Führungsglieder 38 und 39 in das in der betreffenden Schlaufe 36 enthaltene formsteife Rohr des Zugstabs 37 ein.

Sobald die Endlage erreicht ist, wird der Getriebemotor 46 stillgesetzt. Die ausgefahrene Endlage ist in Fig. 5 gezeigt.

Der Getriebemotor 46 ist selbsthaltend und arretiert die Schubglieder 56 und 57 in der jeweils erreichten Stellung.

Das Abschalten des Getriebemotors 46 erfolgt mit Hilfe von Endschaltern oder indem die Führungsglieder 38 und 39 an Anschläge anlaufen, so dass ein in einer Elektronik auszuwertender Blockierstrom auftritt, der zum Abschalten führt.

Die Rollobahn 35 wird nunmehr zwischen dem Zugstab 37 und der Wickelwelle 23 aufgespannt gehalten.

Zum Einfahren wird der Getriebemotor 46 mit der entgegengesetzten Drehrichtung in Gang gesetzt, so dass die beiden Schubglieder 56 und 57 nach unten aus den zugehörigen Führungsschienen 13 heraus bewegt werden. Gleichzeitig läuft der Zugstab 37 mit nach unten, weil durch die Wirkung des Federmotors 34 der Wickelwelle 23 die Rollobahn 35 ständig unter Spannung gehalten wird.

Zufolge der Konstruktion des Fensterrollos 12 weist der Zugstab 37 eine konstruktiv vorgegebene Solllage (Winkellage) gegenüber der Wickelwelle 23 auf. In der Solllage treten keine Spannungskomponenten auf, die parallel zu der Wickelwelle 23 liegen. Alle Zugspannungen in der Rollobahn 35 sind rechtwinkelig zu der Wickelwelle 23 ausgerichtet, gleichgültig wie viel Rollobahn 35 von der Wickelwelle 23 abgezogen ist. Im Falle des gezeigten Heckscheibenrollos ist konstruktiv vorgegebene Solllage eine Lage, in der der Zugstab 37 parallel zu der Wickelwelle 23 liegt.

Auf diese konstruktiv vorgegebene Solllage werden der Zuschnitt für die Rollobahn 35 und die Lage der Schubglieder 56, 57 ausgerichtet.

Aufgrund von Zuschnitttoleranzen wird die konstruktiv vorgegebene Solllage nicht erreicht, sondern nur eine tatsächliche Sollage. Montagetoleranzen bei den Schubgliedern 56, 57 führen dazu, dass die Schubglieder 56, 57 sich nicht entsprechend der konstruktiv vorgegebenen Solllage gegenüber der Wickelwelle 23 bewegen; ein Schubglied wird dem anderen immer etwas voreilen. Das Zusammenwirken der Zuschnitttoleranz und der Montagetoleranz ergibt eine mehr oder weniger starke Verlagerung des Zugstabs 37 aus der natürlichen Lage. Dieser Verlagerung wirkt die Rollobahn entgegen, weshalb ohne Gegenmaßnahmen in der Rollobahn 35 zu Spannungen induziert werden, die schräg gegenüber der Längachse der Wickelwelle 23 verlaufen, weil die Schubglieder 56, 57 den Zugstab 37 aus seiner natürlichen Lage in eine aufgezwungene Lage zu drängen versuchen.

Weil jedoch die Wickelwelle 23 schwenkbar mit Hilfe des Lagerbügels 22 gelagert ist, kann sich die Wickelwelle 23 begrenzt schräg und damit entsprechend der tatsächlichen Lage des Zugstabs 37 ausrichten, in die der Zugstab 37 durch die Schubglieder 56, 57 gezwungen wird. Quer verlaufende Spannungskomponenten in der Rollobahn 35 sind ausgeschlossen. Die Auswirkungen, die entstehen, weil die Lage des Zugstabs 37 nicht mit der Solllage gemäß Zuschnitt übereinstimmt werden zumindest vermindert.

Mit Hilfe der beiden Federn 31 und 32 wird der Bügel 22 in die zentrierte Lage vorgespannt. Ein Taumeln um die Querachse und somit ein Klappern während der Fahrt wird ausgeschlossen.

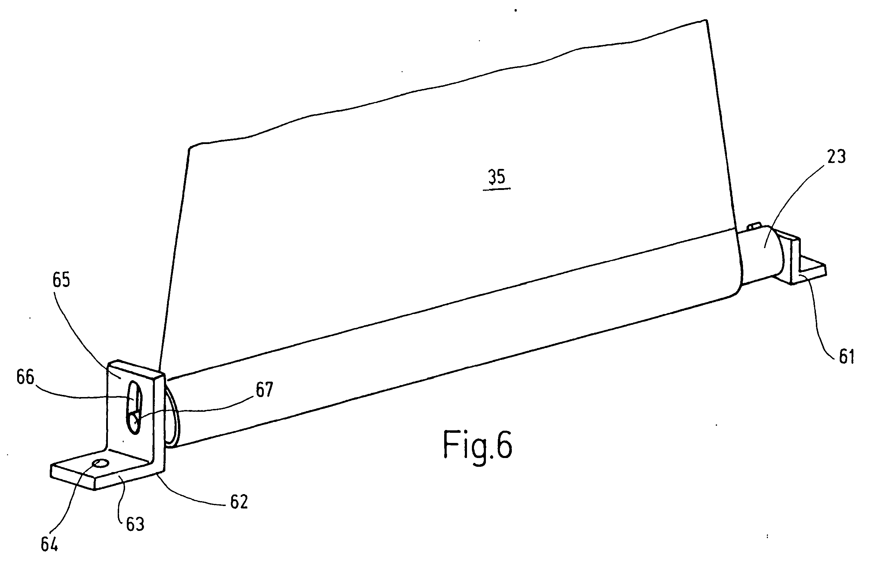

Eine weitere Möglichkeit Zugspannungen abzubauen, die entstehen, weil die Schubglieder 56 und 57 den Zugstab 37 aus seiner natürlichen Lage herausdrehen oder Verkanten ist in Fig. 6 gezeigt.

Anstatt, wie in Fig. 4 veranschaulicht, einen Bügel 22 zu verwenden, in dem die Wickelwelle 23 gelagert ist, ist bei dem Ausführungsbeispiel nach Fig. 6 die Wickelwelle 23 in ihrem, bezogen auf die Darstellung, rechten Ende in einem ortsfesten Lagerbock 61 ortsfest gelagert. Hier stützt sich auch das ortsfeste Ende des Federmotors 34 ab. Allerdings hat der in Fig. 6 nicht erkennbare Lagerzapfen der Wickelwelle 23 ein gewisses Kippspiel.

Am gegenüberliegenden Ende befindet sich ein weiterer karosseriefester Lagerbock 62, der beispielsweise mit seinem Schenkel 63 und einer entsprechenden Befestigungsbohrung 64 an einer tragenden Struktur des Fahrzeugs befestigt ist. Ein weiterer Schenkel 65 des Lagerbocks 8 liegt in einer Ebene, auf der die Wickelwelle 23 senkrecht steht. In diesem Schenkel 65 ist ein Langloch 66 enthalten, das einen entsprechenden Lagerzapfen 67 der Wickelwelle 23 drehbar aufnimmt. Die lange Achse des Langloches 66 liegt in Richtung etwa parallel zu der Ebene, die durch die aufgespannte Rollobahn 35 definiert wird.

Der Lagerzapfen 67 kann sich aus der in der Figur gezeigten Position, in der er dem Schenkel 63 benachbart ist, weitgehend frei in die andere Endstellung in dem Langloch 66 bewegen. Damit die Beweglichkeit zustande kommt, ist das andere Ende der Wickelwelle in dem Lagerbock 61 entsprechend kippbeweglich.

In der Ruhestellung, wie sie in Fig. 6 gezeigt ist, liegt die Wickelwelle in jenem Ende Langloches, dass der ungünstigsten Toleranzpaarung aus Zuschnitttoleranz und Montagetoleranz entspricht, so dass bei dieser ungünstigsten Paarung auf alle Fälle jenes Schubglied, beispielsweise das Schubglied 57, zuerst mit dem Führungsglied 38 in Eingriff kommt, das dem Langloch 66 bzw. dem Lagerbock 62 unmittelbar benachbart ist.

Die Wickelwelle 23 kann sich infolge der Führung in dem Langloch 66 und der weitgehend ortsfesten Halterung am anderen Ende in dem Lagerbock 61 geringfügig schrägstellen und sich so der Lage des Zugstabs 37 anpassen, die dem Zugstab 36 aufgrund der Wirkung der beiden Schubglieder 56 und 57 aufgezwungen wird.

Je stärker bei dem gewählten Ausführungsbeispiel das Schubglied 57 dem Schubglied 56 vorauseilt umso stärker wird der Lagerzapfen 67 in dem Langloch 66 angehoben (wiederum bezogen auf Fig. 6). Quer verlaufende Spannungen aufgrund eines unsymmetrischen Ausfahrens des Zugstabs 37 werden weitgehend vermieden.

Bei den zuvor erläuterten Ausführungsbeispielen war jeweils die Wickelwelle 23 um eine Querachse begrenzt schwenkbar. Im Falle des Ausführungsbeispiels nach Fig. 4 liegt die Querachse etwa in der Mitte der Längserstreckung der Wickelwelle 23, während sie bei der Ausführungsform nach Fig. 6 durch einen der Lagerzapfen am Ende der Wickelwelle 23 geht.

Ein Fensterrollo weist eine Wickelwelle und eine daran befestigte Rollobahn auf. Die Rollobahn ist mit einem Zugstab versehen, der an beiden Enden durch Antriebsglieder längs der Führungsschienen bewegt wird. Um Montagetoleranzen oder Zuschnittstoleranzen zu kompensieren, ist eine Ausgleichseinrichtung vorhanden, die dafür sorgt, dass keine allzu großen Spannungen in der Rollobahn auftreten, die parallel zu der Wickelwelle liegen und zu schräg verlaufenden Wellen in der aufgespannten Rollobahn führen würden.

## Patentansprüche

1. Fensterrollo (12) zum Regulieren des Lichteintritts durch ein Fenster in einen Innenraum eines Kraftfahrzeugs,
mit wenigstens einer Wickelwelle (23), die drehbar gelagert ist,
mit wenigstens einer Rollobahn (35), die mit einer Kante an der Wickelwelle (23) befestigt ist, deren dazu parallele Kante (36) mit einem zugehörigen Zugstab (37) verbunden ist und die seitliche Längskanten aufweist, wobei der Zugstab (37) beim Ausfahren der Rollobahn (35) eine von der Position der Rollobahn (35) abhängige Solllage gegenüber der Wickelwelle (23) aufweist, in der keine Querspannungen in der Rollobahn (35) auftreten,
mit wenigsten einem Paar von Führungsmitteln (13), von denen sich jedes seitlich neben der aufgespannten Rollobahn (35) erstreckt und die jeweils wenigsten eine Führungsnut (19) enthalten, in denen der Zugstab (37) endseitig geführt ist,
mit einer Antriebseinrichtung (45), die ein erstes und ein zweites Antriebsglied (56,57) aufweist, das derart angeordnet ist, dass ein Wirkende des ersten Antriebsglieds (56) mit dem einen Ende des Zugstabs (37) und das Wirkende des zweiten Antriebslieds (57) mit dem anderen Ende des Zugstabs (37) zusammenwirkt,
mit einer Ausgleichseinrichtung (22,66), die dazu eingerichtet ist, ein Verlagern des Zugstabs (37) aus der Solllage durch die Antriebsglieder (56,57) zumindest zu vermindern, wobei zu der Ausgleichseinrichtung (22,66) ein Lagerbügel (22) gehört, in dem die zumindest eine Wickelwelle (23) endseitig gelagert ist und der seinerseits bezüglich einer Achse in dem Fahrzeug an einem fahrzeugfesten Sockel (29) rechwinklig zur Drehachse der Wickelwelle (23) schwenkbar gelagert ist, und
mit Federmittel (31,32), durch die der Lagerbügel (22) in eine zentrierte Stellung elastisch vorgespannt ist.

2. Fensterrollo (12) zum Regulieren des Lichteintritts durch ein Fenster in einen Innenraum eines Kraftfahrzeugs,
mit wenigstens einer Wickelwelle (23), die drehbar gelagert ist,
mit wenigstens einer Rollobahn (35), die mit einer Kante an der Wickelwelle (23) befestigt ist, deren dazu parallele Kante (36) mit einem zugehörigen Zugstab (37) verbunden ist und die seitliche Längskanten aufweist, wobei der Zugstab (37) beim Ausfahren der Rollobahn (35) eine von der Position der Rollobahn (35) abhängige Solllage gegenüber der Wickelwelle (23) aufweist, in der keine Querspannungen in der Rollobahn (35) auftreten,
mit wenigsten einem Paar von Führungsmitteln (13), von denen sich jedes seitlich neben der aufgespannten Rollobahn (35) erstreckt und die jeweils wenigsten eine Führungsnut (19) enthalten, in denen der Zugstab (37) endseitig geführt ist,
mit einer Antriebseinrichtung (45), die ein erstes und ein zweites Antriebsglied (56,57) aufweist, das derart angeordnet ist, dass ein Wirkende des ersten Antriebsglieds (56) mit dem einen Ende des Zugstabs (37) und das Wirkende des zweiten Antriebslieds (57) mit dem anderen Ende des Zugstabs (37) zusammenwirkt,
mit einer Ausgleichseinrichtung (22,66), die dazu eingerichtet ist, ein Verlagern des Zugstabs (37) aus der Solllage durch die Antriebsglieder (56,57) zumindest zu vermindern, wobei zu der Ausgleichseinrichtung (22,66) wenigstens eine Wickelwellenlagerung (62) gehört, die der Wickelwelle (23) lediglich an einem Ende eine Bewegung in Richtung lediglich parallel zu der durch die aufgespannte Rollobahn (35) definierten Ebene ermöglicht.

3. Fensterrollo nach Anspruch 1 oder 2, **dadurch gekennzeichnet, dass** die Ausgleichseinrichtung (22,66) derart gestaltet ist, dass sie ein Verlagern des Zugstabs (37) aus der Solllage verhindert, wenn das Wirkende des ersten Antriebsglieds (57) von der Wickelwelle (23) einen anderen effektiven Abstand als das Wirkende des zweiten Antriebsglieds (57).

4. Fensterrollo nach Anspruch 1 oder 2, **dadurch gekennzeichnet, dass** die Führungsmittel (13) ein Paar Führungsnuten (19) bilden, die seitlich der aufgespannten Rollobahn (35) verlaufen und der Führung des Zugstabs (37) dienen.

5. Fensterrollo nach Anspruch 4, **dadurch gekennzeichnet, dass** die Führungsnuten (19) hinterschnittene Führungsnuten sind.

6. Fensterrollo nach Anspruch 1 oder 2, **dadurch gekennzeichnet, dass** der Wickelwelle (23) ein Federmotor (34) zugeordnet ist, der die Wickelwelle (23) im Aufwickelsinn vorspannt.

7. Fensterrollo nach Anspruch 1 oder 2, **dadurch gekennzeichnet, dass** die Rollobahn (23) aus einem Gewirk oder einer gelochten Folie besteht.

8. Fensterrollo nach Anspruch 1 oder 2, **dadurch gekennzeichnet, dass** der Zugstab (37) längenverstellbar ist, derart, dass sie in der Lage sind, dem sich ändernden Abstand der Führungsnuten (19) zu folgen.

9. Fensterrollo nach Anspruch 1 oder 2, **dadurch gekennzeichnet, dass** die Antriebseinrichtung (45) zum Bewegen der beiden Antriebsglieder (56,57) einen Getriebemotor (46) umfasst.

10. Fensterrollo nach Anspruch 1 oder 2, **dadurch gekennzeichnet, dass** die Antriebsglieder (56,57) biegsame linienförmige Schubglieder sind, die knicksicher zwischen dem Getriebemotor (46) und der betreffenden Führungsnut (19) geführt sind.

11. Fensterrollo nach Anspruch 1 oder 2, **dadurch gekennzeichnet, dass** die Antriebsglieder (56,57) angenähert zylindrische Gebilde sind, die mit einer Verzahnung (59) auf der Außenseite versehen sind, die über die Länge mit konstanter Teilung durchläuft.

12. Fensterrollo nach Anspruch 11, **dadurch gekennzeichnet, dass** die Verzahnung (59) von einer auf der Außenseite schraubenförmig verlaufenden Rippe gebildet ist.

13. Fensterrollo nach Anspruch 9, **dadurch gekennzeichnet, dass** die Antriebsglieder (56,57) mit dem Getriebemotor (46) formschlüssig zusammenwirken.

## Claims

1. Window roller blind (12) for regulating the entry of light through a window into an interior of a motor vehicle,
with at least one winding shaft (23), which is rotatably disposed,
with at least one blind sheet (35), which is fastened to the winding shaft (23) at one edge, of which the edge (36) parallel thereto is connected to an associated pull rod (37) and which has lateral longitudinal edges, wherein during extension of the blind sheet (35) the pull rod (37) has a desired position, which is dependent on the position of the blind sheet (35), relative to the winding shaft (23), in which position no transverse stresses occur in the blind sheet (35),
with at least one pair of guide elements (13), each of which extends laterally next to the opened out blind sheet (35) and which respectively contain at least one guide groove (19), in which the pull rod (37) is guided at the end,
with a drive means (45), which has a first and a second drive member (56, 57), which is arranged in such a manner that an operative end of the first drive member (56) cooperates with one end of the pull rod (37) and the operative end of the second drive member (57) cooperates with the other end of the pull rod (37),
with an equalising means (22, 66), which is arranged to at least reduce a displacement of the pull rod (37) out of the desired position through the drive members (56, 57), wherein belonging to the equalising means (22, 66) is a bearing bracket (22), in which the at least one winding shaft (23) is disposed at the end and which is itself disposed to swivel relative to an axis in the vehicle on a base (29) fixed to the vehicle at right angles to the rotational axis of the winding shaft (23), and
with spring elements (31, 32), through which the bearing bracket (22) is elastically biased into a centred position.

2. Window roller blind (12) for regulating the entry of light through a window into an interior of a motor vehicle,
with at least one winding shaft (23), which is rotatably disposed,
with at least one blind sheet (35), which is fastened to the winding shaft (23) at one edge, of which the edge (36) parallel thereto is connected to an associated pull rod (37) and which has lateral longitudinal edges, wherein during extension of the blind sheet (35) the pull rod (37) has a desired position, which is dependent on the position of the blind sheet (35), relative to the winding shaft (23), in which position no transverse stresses occur in the blind sheet (35),
with at least one pair of guide elements (13), each of which extends laterally next to the opened out blind sheet (35) and which respectively contain at least one guide groove (19), in which the pull rod (37) is guided at the end,
with a drive means (45), which has a first and a second drive member (56, 57), which is arranged in such a manner that an operative end of the first drive member (56) cooperates with one end of the pull rod (37) and the operative end of the second drive member (57) cooperates with the other end of the pull rod (37),
with an equalising means (22, 66), which is arranged to at least reduce a displacement of the pull rod (37) out of the desired position through the drive members (56, 57), wherein belonging to the equalising means (22, 66) is at least one winding shaft mounting (62), which allows the winding shaft (23) to perform a movement merely at one end only in a direction parallel to the plane defined by the opened out blind sheet (35).

3. Window roller blind according to Claim 1 or 2, **characterised in that** the equalising means (22, 66) is configured in such a manner that it prevents a displacement of the pull rod (37) out of the desired position when the operative end (23) of the first drive member (57) is at a different effective distance from the winding shaft (23) than the operative end of the second drive member (57).

4. Window roller blind according to Claim 1 or 2, **characterised in that** the guide elements (13) form a pair of guide grooves (19), which run laterally of the opened out blind sheet (35) and serve to guide the pull rod (37).

5. Window roller blind according to Claim 4, **characterised in that** the guide grooves (19) are undercut guide grooves.

6. Window roller blind according to Claim 1 or 2, **characterised in that** the winding shaft (23) has an associated spring motor (34), which biases the winding shaft (23) in the wind-up direction.

7. Window roller blind according to Claim 1 or 2, **characterised in that** the blind sheet (24) is made of a knitted fabric or a perforated foil.

8. Window roller blind according to Claim 1 or 2, **characterised in that** the pull rod (37) is adjustable in length such that it is able to follow the changing distance between the guide grooves (19).

9. Window roller blind according to Claim 1 or 2, **characterised in that** the drive means (45) comprises a geared motor (46) to move the two drive members (56,57).

10. Window roller blind according to Claim 1 or 2, **characterised in that** the drive members (56, 57) are flexible linear pushing members, which are guided between the geared motor (46) and the respective guide groove (19) to be secure against buckling.

11. Window roller blind according to Claim 1 or 2, **characterised in that** the drive members (56, 57) are approximately cylindrical structures, which are provided with a tooth system (59) on the outside, which runs over the length with constant pitch.

12. Window roller blind according to Claim 11, **characterised in that** the tooth system (59) is formed by a rib running in a coil shape on the outside.

13. Window roller blind according to Claim 9, **characterised in that** the drive members (56, 57) cooperate positively with the geared motor (46).

## Revendications

1. Store à enrouleur (12) destiné à régler l'entrée de la lumière à travers une fenêtre, dans l'espace interne d'un véhicule automobile, comprenant
- au moins un premier arbre d'enroulement (23) monté en rotation,
- au moins une bande de store (35) fixée par un bord sur l'arbre d'enroulement (23), dont le bord (36) parallèle à cet arbre est relié à une tige de tension (37) correspondante, et qui présente des bords latéraux, la tige de tension (37) présentant, quand la bande de store (35) sort, une position de consigne par rapport à l'arbre d'enroulement (23) qui dépend de la position de la bande (35) et dans laquelle il n'existe aucune tension transversale dans cette bande,
- au moins une paire de moyens de guidage (13) dont chacune est disposée latéralement près de la bande de store (35) tendue, chaque moyen de guidage présentant au moins une rainure de guidage (19) dans laquelle la tige de tension (37) est guidée par une extrémité,
- un dispositif d'entraînement (45) comportant un premier et un second organe d'entraînement (56, 57) disposés de manière qu'une extrémité active du premier organe d'entraînement (56) coopère avec une extrémité de la tige de tension (37) et que l'extrémité active du second organe d'entraînement (57) coopère avec l'autre extrémité de la tige de tension (37),
- un dispositif de compensation (22, 66) conçu au moins pour diminuer l'écart de la tige de tension (37) par rapport à sa position de consigne produit par les organes d'entraînement (56, 57), ce dispositif de compensation comportant un étrier de paliers (22) dans lequel l'arbre d'enroulement (23) au nombre d'un au moins est monté par ses extrémités en pouvant basculer, et qui de son côté est monté basculant perpendiculairement à l'axe de rotation de l'arbre d'enroulement (23), sur un axe porté par un socle (29) fixé au véhicule,
- des moyens élastiques (31, 32) qui exercent sur l'étrier de paliers (22) une précontrainte élastique en direction d'une position centrée.

2. Store à enrouleur (12) destiné à régler l'entrée de la lumière à travers une fenêtre, dans l'espace interne d'un véhicule automobile, comprenant
- au moins un premier arbre d'enroulement (23) monté en rotation,
- au moins une bande de store (35) fixée par un bord sur l'arbre d'enroulement (23), dont le bord (36) parallèle à cet arbre est relié à une tige de tension (37) correspondante, et qui présente des bords latéraux, la tige de tension (37) présentant, quand la bande de store (35) sort, une position de consigne par rapport à l'arbre d'enroulement (23) qui dépend de la position de la bande (35) et dans laquelle il n'existe aucune tension transversale dans cette bande,
- au moins une paire de moyens de guidage (13) dont chacune est disposée latéralement près de la bande de store (35) tendue, chaque moyen de guidage présentant au moins une rainure de guidage (19) dans laquelle la tige de tension (37) est guidée par une extrémité,
- un dispositif d'entraînement (45) comportant un premier et un second organe d'entraînement (56, 57) disposés de manière qu'une extrémité active du premier organe d'entraînement (56) coopère avec une extrémité de la tige de tension (37) et que l'extrémité active du second organe d'entraînement (57) coopère avec l'autre extrémité de la tige de tension (37),
- un dispositif de compensation (22, 66) conçu au moins pour diminuer l'écart de la tige de tension (37) par rapport à sa position de consigne produit par les organes d'entraînement (56, 57), ce dispositif de compensation (22, 66) comprenant au moins un palier d'arbre d'enroulement (62) qui permet à l'arbre d'enroulement (23) d'effectuer à une seule de ses extrémités un déplacement parallèle au plan défini par la bande de store tendue.

3. Store à enrouleur selon la revendication 1 ou 2, **caractérisé en ce que** le dispositif de compensation (22, 66) est conçu de manière à empêcher que la tige de tension (36) se décale par rapport à la position de consigne quand l'extrémité active du premier organe d'entraînement (56) présente par rapport à l'arbre d'enroulement (23) une distance effective différente de celle présentée par l'extrémité active du second organe d'entraînement (57).

4. Store à enrouleur selon la revendication 1 ou 2, **caractérisé en ce que** les moyens d'entraînement (13) forment une paire de rainures de guidage disposée latéralement par rapport à la bande de store tendue et servant au guidage de la tige de tension (37).

5. Store à enrouleur selon la revendication 4, **caractérisé en ce que** les rainures de guidage (19) sont des rainures en contredépouille.

6. Store à enrouleur selon la revendication 1 ou 2, **caractérisé en ce qu'**à l'arbre d'enroulement (23) est associé un moteur élastique (34) qui précontraint cet arbre dans le sens d'enroulement.

7. Store à enrouleur selon la revendication 1 ou 2, **caractérisé en ce que** la bande de store (23) est constituée par un tissu à mailles ou par une feuille perforée.

8. Store à enrouleur selon la revendication 1 ou 2, **caractérisé en ce que** la tige de tension (37) est réglable en longueur de manière à pouvoir suivre l'espacement qui varie des rainures de guidage (19).

9. Store à enrouleur selon la revendication 1 ou 2, **caractérisé en ce que** le dispositif d'entraînement (45) servant à déplacer les organes d'entraînement (56, 57) comprend un motoréducteur (46).

10. Store à enrouleur selon la revendication 1 ou 2, **caractérisé en ce que** les organes d'entraînement (56, 57) sont des organes coulissants linéaires et flexibles guidés sans flambage entre le motoréducteur (46) et la rainure de guidage (19) correspondante.

11. Store à enrouleur selon la revendication 1 ou 2, **caractérisé en ce que** les organes d'entraînement (56, 57) sont des corps à peu près cylindriques portant sur leur surface externe une denture (59) présentant une division constante en longueur.

12. Store à enrouleur selon la revendication 11, **caractérisé en ce que** la denture (59) est constituée par une nervure hélicoïdale réalisée sur la surface externe.

13. Store à enrouleur selon la revendication 9, **caractérisé en ce que** les organes d'entraînement (56, 57) coopèrent avec le motoréducteur (46) avec verrouillage par combinaison de formes.
